# FASCICULE DE BREVET EUROPEEN

(11) **EP 0 577 498 B1**
(45) Date de publication et mention de la délivrance du brevet: **11.02.1998**
(21) Numéro de dépôt: 93401673.4
(22) Date de dépôt: 29.06.1993
(51) Int. Cl.: H01L 29/808, H01L 29/73, H01L 21/337

(54) **Transistor JFET vertical à mode de fonctionnement bipolaire optimisé et procédé de fabrication correspondant**
Vertikaler JFET-Transistor mit optimiertem Betrieb und Verfahren zur Herstellung
Vertical JFET transistor having an optimized operation and process for fabricating the same

(30) Priorité: 02.07.1992 FR 9208179
(43) Date de publication de la demande: 05.01.1994
(73) Titulaire: FRANCE TELECOM, 75015 Paris (FR)
(72) Inventeur: Chantre, Alain, F-38120 Saint-Egrève (FR)
(74) Mandataire: Casalonga, Axel

(56) Documents cités:
- EP-A- 0 430 279
- DE-A- 3 736 009
- US-A- 4 812 894
- GAAS IC SYMPOSIUM TECHNICAL DIGEST 22-25 OCTOBER 1989, SAN DIEGO, CALIFORNIA, US pages 313 - 316 KURIYAMA ET AL. '15 GBPS MUX/DMUX IMPLEMENTED WITH ALGAAS/GAAS HBTS'

## Description

L'invention concerne les structures semi-conductrices susceptibles de former un transistor à effet de champ vertical à jonction, capable en outre de fonctionnement bipolaire.

Un transistor classique à effet de champ vertical à jonction, ou plus simplement transistor JFET vertical, comporte, en raison du procédé de fabrication généralement employé, une région de grille implantée au sein d'un substrat semi-conducteur. Le substrat possède un premier type de conductivité (N dans le cas d'un transistor JFET à canal N) tandis que la région de grille a le type de conductivité opposé (P dans le cas présent). Le substrat incorpore au moins en partie, la région de canal, et, dans sa partie inférieure la région de drain. Les documents US 4 812 894 et DE-A-37 36 009 décrivent des structures classiques de transistors JFET tandis que le document EP-A-0 430 279 décrit une structure classique d'un transistor bipolaire à hétérojonction.

Lorsque, par exemple, la grille d'un transistor JFET vertical à canal N est polarisée en direct par rapport à la source, les porteurs minoritaires (trous) injectés dans la région de canal constituent une "base" électrique entre la source (qui fait office d'émetteur) et le drain (qui fait office de collecteur). Le transistor fonctionne alors en mode bipolaire.

Un tel mode de fonctionnement, caractérisé par une transconductance très élevée, est particulièrement intéressant pour les applications haute vitesse.

L'optimisation de ce mode de fonctionnement bipolaire dépend notamment de la largeur de la base ainsi créée. Or, dans les structures de transistor actuellement existantes, il n'est pas possible de contrôler cette largeur.

L'invention vise à apporter une solution plus satisfaisante à ce problème.

Un but de l'invention est d'optimiser le mode de fonctionnement bipolaire d'un transistor JFET vertical et d'obtenir ainsi notamment un transistor à très haute vitesse de commutation.

L'invention a encore pour but de proposer un tel transistor qui puisse être fabriqué simplement à partir de filières technologiques déjà existantes.

Un autre but de l'invention consiste à minimiser, voire à s'affranchir, des capacités parasites grille/substrat produites par la jonction PN correspondante, formées habituellement au sein de ce transistor.

L'invention a également pour but de minimiser les capacités parasites drain/substrat.

L'invention propose donc un transistor à effet de champ vertical à jonction, comprenant une structure semi-conductrice comportant une couche interne semi-conductrice s'étendant au sein de la région de canal entre la région de grille, cette couche interne étant réalisée en un matériau semi-conducteur ayant une largeur de bande interdite plus faible que celle du matériau formant les régions de canal et de grille, et le même type de conductivité que celui de la région de canal; par ailleurs, l'hétérojonction formée entre cette couche inteme et la région de canal présente une discontinuité de bande située dans la bande de valence dans le cas d'un canal de type N (grille de type P) ou dans la bande de conduction dans le cas d'un canal de type P (grille de type N).

L'épaisseur de cette couche semi-conductrice interne est avantageusement de l'ordre de quelques dizaines d'Ångströms.

Selon un mode de réalisation de l'invention, le matériau formant la région de grille et la région de canal est du silicium, tandis que le matériau formant la couche inteme semi-conductrice est un alliage de silicium/germanium. On peut cependant utiliser comme matériau formant la couche interne semi-conductrice, un matériau III-V, tandis que le matériau formant les régions de grille et de canal peut être alors un alliage ternaire de ce matériau III-V.

Selon un mode de réalisation de l'invention, la structure semi-conductrice d'un tel transistor à effet de champ vertical à jonction, comprend une région intermédiaire, susceptible de former la région de canal, ayant un premier type de conductivité, surmontant une première région susceptible de former la région de drain, incluse dans le substrat, ayant également le premier type de conductivité et avantageusement surdopée par rapport à la région intermédiaire. Cette région intermédiaire possède une partie saillante surmontée d'une deuxième région, susceptible de former la région de source, ayant également le premier type de conductivité et avantageusement surdopée par rapport à la région intermédiaire. Cette structure semiconductrice comprend également une troisième région, susceptible de former la région de grille, ayant le type de conductivité opposé, avantageusement surdopée, disposée de part et d'autre d'une partie de la région intermédiaire, et séparée de la deuxième région par une séparation isolante, ou espaceurs, disposée autour de la partie saillante; la couche interne s'étend alors au sein de la région intermédiaire entre la région de grille.

Afin de minimiser, voire de s'affranchir, des capacités parasites grille/substrat, la structure semi-conductrice comporte avantageusement une couche isolante disposée à l'extérieur de la région de canal entre la région de grille et le substrat.

Cette couche isolante a avantageusement une épaisseur au moins égale à la largeur de la zone de charge d'espace d'une jonction PN qui serait réalisée à partir du matériau semi-conducteur de base du transistor à effet de champ. Elle peut être comprise entre environ 0,2 µm et environ 1 µm, de préférence de l'ordre de 0,5 µm.

Lorsque le transistor est réalisé à base de silicium, les régions de canal, de source et de drain comportent avantageusement du silicium monocristallin, tandis que la couche isolante est du dioxyde de silicium et que la région de grille comporte du silicium polycristallin.

Afin de minimiser les capacités parasites drain/substrat, il est particulièrement avantageux de prévoir un substrat sur isolant.

Un tel transistor peut être utilisé dans un mode de fonctionnement bipolaire; dans ce cas, la région de drain constitue la région de collecteur, la région de source, celle de l'émetteur, et la région de grille, celle de la base.

L'invention a également pour objet un procédé de fabrication d'une structure semi-conductrice susceptible de former un transistor à jonction, à effet de champ ou bipolaire.

Selon une première variante de ce procédé, compatible avec une technologie de fabrication du type BiCMOS,
a) on dépose sur un substrat semi-conducteur comportant une première région ayant un premier type de conductivité (par exemple le type N), une couche superficielle en un matériau semi-conducteur ayant le premier type de conductivité et une largeur de bande interdite plus faible que celle du matériau de la première région, et apte à former une hétérojonction comportant une discontinuité de bande située dans la bande de valence dans le cas où le premier type de conductivité est N et dans la bande de conduction dans le cas où le premier type de conductivité est P,
b) on élimine une partie de cette couche superficielle pour mettre à nu la partie correspondante du substrat et délimiter ainsi une couche dite interne,
c) on dépose sur la structure ainsi obtenue, un empilement comportant une autre couche d'un matériau semi-conducteur, identique à celui formant ladite première région, puis une couche supérieure en un autre matériau semi-conducteur, ayant également le premier type de conductivité,
d) on retire, dans une zone située de part et d'autre de la couche interne, une partie de l'empilement jusqu'au voisinage supérieur de ladite couche interne, de façon à former une partie saillante comportant dans sa partie supérieure une partie de la couche supérieure formant une deuxième région susceptible de constituer la région de source,
e) on implante dans le substrat, de part et d'autre de la partie saillante, une troisième région, susceptible de former la région de grille, venant au contact de la couche interne et ayant un type de conductivité opposé au premier, par exemple le type P, et on réalise des espaceurs isolants au contact des flancs de la partie saillante, et
f) on métallise une partie au moins des première, deuxième et troisième régions.

Le matériau semi-conducteur formant la couche supérieure de l'empilement, destiné à former la région de source ou émetteur, est avantageusement du silicium polycristallin surdopé.

Selon un mode de mise en oeuvre du procédé, dans l'étape e), on effectue tout d'abord une première implantation de dopant, destinée à conférer à la troisième région le deuxième type de conductivité, puis on dispose les espaceurs de part et d'autre de la région saillante et on effectue une deuxième implantation de dopant, destinée à assurer un surdopage graduel de la région de grille.

Selon une autre variante du procédé de fabrication selon l'invention,
a) on forme sur un substrat semi-conducteur contenant une première région ayant un premier type de conductivité, un empilement comportant une couche d'un matériau semi-conducteur ayant un type de conductivité opposé au premier, encadrée par deux couches de matériaux isolants,
b) on réalise dans cet empilement, un orifice principal s'étendant jusqu'à la première région,
c) on forme dans cet orifice principal, une région intermédiaire, à partir d'un matériau semi-conducteur, ayant le premier type de conductivité, une couche interne en un matériau semi-conducteur ayant le premier type de conductivité et une largeur de bande interdite plus faible que celle du matériau de la première région, et apte à former une hétérojonction comportant une discontinuité de bande située dans la bande de valence dans le cas où le premier type de conductivité est N et dans la bande de conduction dans le cas où le premier type de conductivité est P, ainsi qu'une deuxième région surmontant cette région intermédiaire, ayant également le premier type de conductivité,
d) on découvre la face supérieure de la couche semi-conductrice de l'empilement dans une région située à distance et à l'extérieur de la région de canal, et
e) on réalise des métallisations sur une partie au moins de la première et de la deuxième régions, ainsi que sur une partie au moins de la couche semi-conductrice de l'empilement, découverte.

Il est particulièrement avantageux, de surdoper les première et deuxième régions ainsi que la couche semi-conductrice de l'empilement, afin d'obtenir un meilleur contact électrique avec les différentes métallisations, notamment dans le cas où la structure semiconductrice est réalisée à base de silicium.

Selon un mode de mise en oeuvre du procédé, la formation de la région intermédiaire, de la couche interne et de la deuxième région, comprend un premier dépôt par épitaxie d'une première couche semiconductrice pour former la partie inférieure de la région intermédiaire, suivie d'un autre dépôt par épitaxie de la couche interne, puis d'un troisième dépôt par épitaxie pour former la partie supérieure de la région intermédiaire, ainsi que la deuxième région. Ces dépôts par épitaxie peuvent être de préférence des dépôts par épitaxie sélective à l'intérieur de l'orifice principal.

La face supérieure de la couche semi-conductrice de l'empilement peut être découverte à partir d'une opération de gravure, telle qu'une opération de gravure ionique réactive.

Afin de réaliser un accès à la première région susceptible de former le drain, on retire la couche semi-conductrice déposée sur la première couche isolante en contact avec le substrat, dans une zone auxiliaire prédéterminée située à distance de celle dans laquelle sera réalisé ledit orifice principal; on dépose ensuite la deuxième couche isolante de l'empilement, on réalise dans cette zone auxiliaire un orifice auxiliaire s'étendant jusqu'à la première région du substrat, et on forme dans cet orifice auxiliaire une région de contact ayant le même type de dopage que celui de la première région.

D'autres avantages et caractéristiques de l'invention apparaîtront à l'examen de la description détaillée ci-après et des dessins annexés sur lesquels :
la figure 1 est une coupe schématique d'un transistor JFET selon l'invention;
les figures 2 et 3 illustrent deux diagrammes de bandes selon deux directions orthogonales, relatifs à l'hétérojonction formée au sein du transistor;

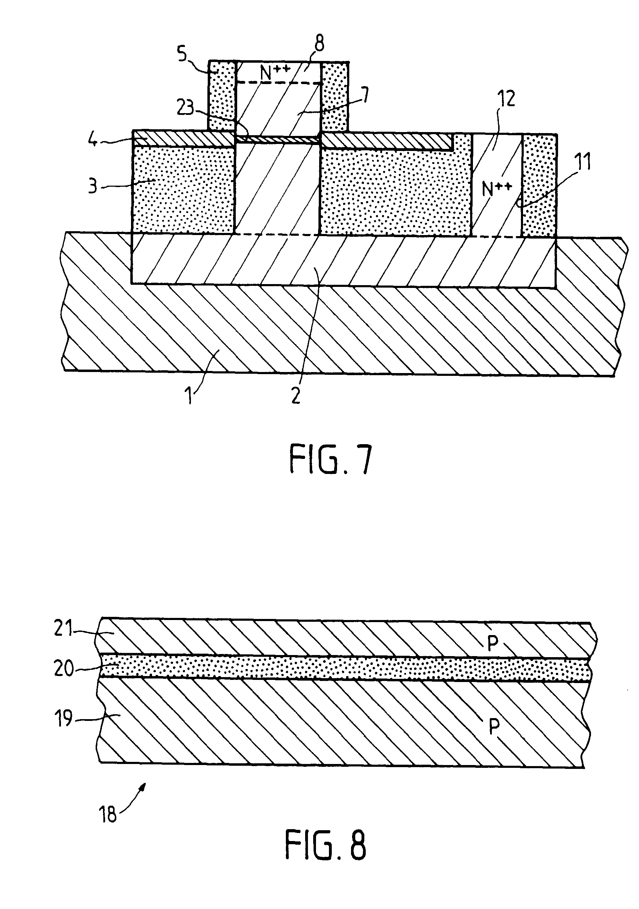

les figures 4 à 7 illustrent différentes étapes d'une première variante du procédé de fabrication selon l'invention;
la figure 8 illustre un autre type de substrat utilisé pour la fabrication d'un tel transistor;
la figure 9 illustre un autre mode de réalisation d'un transistor JFET selon l'invention; et
les figures 10 à 12 illustrent différentes étapes d'une autre variante du procédé de fabrication selon l'invention.

On va maintenant décrire la structure et le procédé de fabrication d'un premier mode de réalisation d'un transistor JFET vertical à canal N, bien que l'invention puisse s'appliquer à un transistor JFET à canal P, en inversant tous les types de dopants par rapport à ce qui va être maintenant décrit.

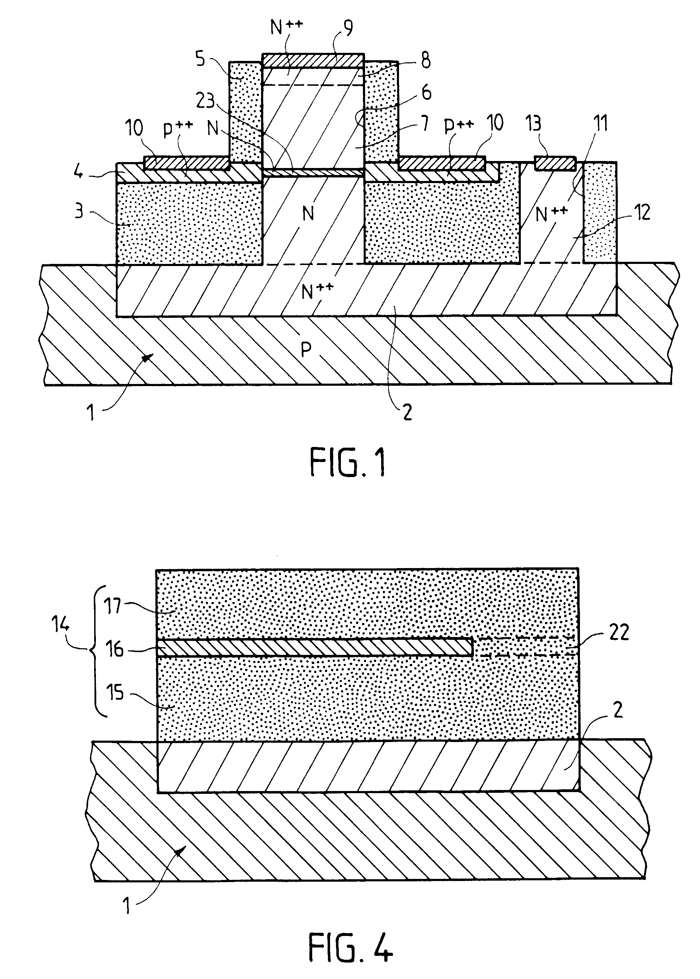

Sur la figure 1, la référence 1 désigne un substrat massif de silicium dopé selon le type de conductivité P (conduction par trous). Dans ce substrat est implantée une première région 2 ayant le type de conductivité opposé, c'est-à-dire N (conduction par électrons). Cette première région est surdopée N⁺⁺, par exemple avec une concentration d'électrons de l'ordre de 10²⁰ cm⁻³, par rapport à une région 7 de silicium N dans laquelle est susceptible de se former le canal du transistor à jonction. La concentration d'électrons dans les régions dopées N est de l'ordre de 10¹⁷ cm⁻³. Cette région intermédiaire, dite de canal, 7 est surmontée par une deuxième région 8, ayant aussi le type de conductivité N et également surdopée par rapport à la région de canal, sur laquelle est prévue une métallisation 9.

Les régions 7 et 8 du transistor JFET sont situées (au moins en partie) à l'intérieur d'un orifice principal 6 ménagé au sein d'un empilement comportant une couche semi-conductrice 4, formée de silicium polycristallin surdopé, ayant une épaisseur de l'ordre de 1000 à 2000 Å et un type de conductivité opposé à celui de la région de canal, c'est-à-dire ici le type P. Sous cette couche semi-conductrice 4, se trouve une première couche isolante 3, sensiblement parallèle à la face supérieure du substrat 1, et s'étendant jusqu'à ce dernier, à l'extérieur de la partie inférieure de la région de canal 7. Cette première couche isolante est réalisée par exemple à partir de dioxyde de silicium et a une épaisseur de l'ordre de 0,5 à 0,7 µm.

Au sein de la région intermédiaire 7, s'étend, entre la couche semi-conductrice 4 surdopée P⁺⁺, une couche 23 réalisée en un alliage de silicium/germanium, Si₁₋ₓGeₓ avec par exemple x=0,5. Cette couche 23 est une couche mince ayant typiquement une épaisseur de l'ordre de quelques dizaines d'Ångströms. Cette couche semiconductrice est dopée N comme la région intermédiaire 7, dite de canal.

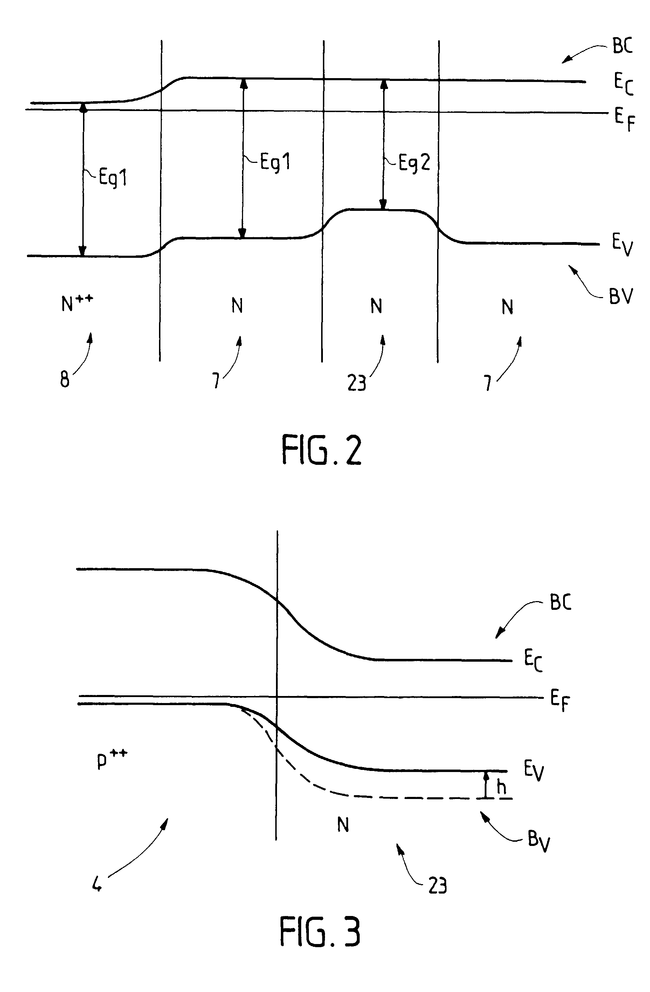

D'une façon générale, le choix des matériaux semi-conducteurs a été effectué pour obtenir une hétérojonction entre cette couche interne 23 et la région dite de canal 7, ayant un diagramme de bande présentant, dans le cas d'un transistor JFET vertical à canal N, une discontinuité de bande située dans la bande de valence. Un tel diagramme, obtenu dans la direction verticale, est illustré sur la figure 2. La référence Ef désigne le niveau de Fermi, tandis que la référence Eg1 désigne la largeur de bande interdite entre le niveau bas Ec de la bande de conduction BC du silicium et le niveau haut Ev de la bande de valence BV du silicium. La référence Eg2 désigne quant à elle, la largeur de bande interdite de l'alliage silicium/ germanium utilisé. Ces deux matériaux ont sensiblement la même bande de conduction, mais présentent une différence de largeur de bande interdite Eg2 - Eg1 sensiblement égale à 0,37 eV pour un alliage Si₁₋ₓGeₓ avec x=0,5. En conséquence, on obtient au niveau de l'hétérojonction une discontinuité de la bande de valence sensiblement égale à 0,37 eV.

Dans le cas où le transistor JFET serait à canal P, il conviendrait alors de choisir un couple de matériaux semi-conducteurs tel que ce diagramme de bande présente une discontinuité de bande dans la bande de conduction.

Corrélativement au diagramme de bandes obtenu dans la direction verticale, le diagramme de bandes selon une direction horizontale, illustré sur la figure 3, montre que l'hétérojonction entre la région semi-conductrice 4 et la couche interne 23 présente une hauteur de barrière de potentiel réduite d'une hauteur h, dans la bande de valence, par rapport à la barrière de potentiel existant normalement entre une jonction P⁺⁺ N de silicium.

Les conséquences de ces diagrammes de bandes d'énergie seront explicitées plus en détail ci-après dans le cadre du fonctionnement bipolaire du transistor JFET.

Bien entendu, il serait possible d'utiliser d'autres couples de matériaux semi-conducteurs pour réaliser de telles hétérojonctions. Le matériau formant la couche interne 23 pourrait être un matériau III-V, c'est-à-dire un matériau comportant en parts égales un élément de la troisième colonne et un élément de la cinquième colonne de la classification périodique de Mendeléeff, tel qu'un alliage d'Arseniure de gallium. Le matériau formant la région semi-conductrice 4 ainsi que la région intermédiaire de canal 7, serait alors un alliage ternaire de ce matériau, comme par exemple un alliage GaAlAs.

Autour de la partie supérieure saillante de la structure incorporant une partie de la région de canal 7 ainsi que la deuxième région 8, sont prévus des espaceurs isolants 5 réalisés également par exemple en dioxyde de silicium. Ces espaceurs ont notamment pour fonction de séparer la deuxième région 8 de la région 4 sur laquelle est prévue également une métallisation 10 s'étendant jusqu'aux espaceurs 5.

Un orifice auxiliaire 11 est ménagé dans une zone auxiliaire du transistor, située à distance de celle dans laquelle se trouve l'orifice principal 6. Cet orifice auxiliaire est rempli par du silicium de type N surdopé, formant une région 12 venant au contact, dans sa partie inférieure, avec la région enterrée 2, et surmontée d'une métallisation 13. On remarquera ici que l'extrémité de la couche semi-conductrice 4 se situe à distance de la région de conductivité opposée 12 contenue dans l'orifice 11.

Lorsque cette structure semi-conductrice est utilisée en tant que transistor à effet de champ à jonction, la couche semi-conductrice 4 constitue la région de grille avec le contact de grille 10, la région surdopée 8 forme la région de source avec le contact de source 9, tandis que la partie de la région 2, située sous la région de canal 7, forme le drain du transistor relié au contact de drain 13 par la région 12 contenue dans l'orifice auxiliaire 11.

Le diamètre de l'orifice 6 a été pris inférieur à 1 µm environ, ce qui permet dans ce mode de réalisation, compte tenu du dopage utilisé, d'avoir un recouvrement significatif des zones de charge d'espace des jonctions grille/source en présence d'une tension de polarisation grille/source V_{GS} nulle, afin d'assurer le bloquage du transistor (transistor normalement fermé : "Normally OFF"). Bien entendu, l'homme du métier comprendra que l'on peut ajuster le diamètre de l'orifice à différentes valeurs, en fonction du matériau utilisé et de son dopage pour obtenir la condition de bloquage à V_{GS} nulle. Par ailleurs, on peut envisager de réaliser dans certaines applications un transistor normalement ouvert ("Normally ON"). L'homme du métier saura ajuster alors le diamètre de l'orifice 6.

Un tel transistor peut être également utilisé en fonctionnement bipolaire. Dans ce cas, les régions de drain, source et grille du transistor à effet de champ, constituent respectivement les régions de collecteur, émetteur et base du transistor bipolaire. Bien entendu, l'utilisation de ce transistor JFET à canal N dans le mode de fonctionnement bipolaire nécessite de polariser en direct la région de grille par rapport à la région de source, c'est-à-dire de prévoir une tension grille/source supérieure à environ 0,7 Volt.

Dans le fonctionnement en mode bipolaire, les diagrammes de bandes illustrés sur les figures 2 et 3 ont essentiellement deux conséquences essentielles :
- l'injection des porteurs minoritaires (trous dans le cas présent) depuis la région de grille (base) est focalisée dans la couche interne 23, grâce à la hauteur de barrière réduite. L'efficacité d'injection dans cette couche est multipliée par un facteur qui est une fonction exponentielle du rapport de la discontinuité de bande ΔeV sur le produit de la constante de Boltzmann par la température. Ce facteur est de l'ordre de 10⁶ pour une température de 300°K et pour un alliage Si₁₋ₓGeₓ (x=0,5), par rapport à l'injection dans la région de canal environnante;
- les porteurs minoritaires (trous) injectés dans la couche 23 y restent confinés grâce aux barrières de potentiel avec le silicium adjacent, provoquées par la discontinuité de bande dans la bande de valence (dans le cas présent).

Cette hétérostructure dans la région de canal permet donc de contrôler précisément la largeur de la base du transistor dans son mode de fonctionnement bipolaire, ce qui n'est pas possible dans un transistor JFET vertical conventionnel. De plus, le fait que cette couche interne soit dopée comme la région intermédiaire de canal, évite les problèmes d'exodiffusion qui auraient tendance à se produire dans le cas d'un dopage non uniforme provoquant un élargissement de cette base électrique. Il est ainsi possible d'obtenir des transistors bipolaires ayant des bases extrêmement minces de l'ordre de quelques dizaines d'Ångströms, ce qui permet d'augmenter considérablement la vitesse de transport dans la base et d'obtenir donc des performances dynamiques excellentes.

Ce transistor a été réalisé sur un substrat massif de type P, ce qui permet notamment d'isoler plusieurs transistors du même type réalisés à partir de la même plaquette de silicium de type P. Bien entendu, on aurait pu réaliser ce transistor à partir d'un substrat de silicium massif de type N, dans lequel aurait été implantée la région surdopée 2.

Par ailleurs, les régions de drain, source et de grille ont été ici surdopées afin d'obtenir un meilleur contact électrique entre le métal et le silicium utilisé comme semi-conducteur de base. Néanmoins, il est possible de s'affranchir d'un tel surdopage de ces régions si l'on utilise un matériau semi-conducteur permettant d'obtenir directement un contact satisfaisant avec les métallisations. De tels matériaux existent parmi les matériaux III-V.

D'une façon générale, la largeur de la première couche isolante 3 située sous la grille à l'extérieur de la région de la zone de canal, peut être prise égale à la largeur de la zone de charge d'espace de la jonction PN existant entre la zone de grille et le substrat dans les transistors JFET verticaux classiques. En effet, la capacité parasite grille/substrat sera déjà réduite grâce à la faible constante diélectrique de l'isolant. On utilisera donc généralement une épaisseur minimale de couche isolante de l'ordre de 0,2 µm.

En ce qui concerne la valeur maximale de cette épaisseur, on ne dépassera pas généralement la valeur de 1 µm de façon à ne pas avoir une résistance verticale d'accès au drain ou au collecteur trop importante.

On va maintenant décrire en détail le procédé de fabrication du transistor de la figure 1 en se référant plus particulièrement aux figures 2 à 5.

La première étape de ce procédé consiste à déposer sur le substrat 1 (figure 2) dans laquelle a été implantée la région 2 de type N surdopée, un empilement 14 constitué d'une première couche d'isolant 15 surmontée d'une couche semi-conductrice 16 d'un type de conductivité opposé à celle de la région 2, elle-même surmontée d'une deuxième couche d'isolant 17.

Concrètement, on dépose tout d'abord sur le substrat 1, d'une façon classique, la couche d'isolant 15 constituée ici de dioxyde de silicium. On dépose ensuite du silicium polycristallin que l'on surdope pour lui conférer le type de conductivité P, et l'on dépose ensuite sur ce silicium polycristallin la deuxième couche d'isolant 17 constituée ici également de dioxyde de silicium.

Dans le cas où l'on souhaite réaliser le contact de drain sur la face avant du transistor, on retire, avant d'effectuer le dépôt de la deuxième couche d'isolant 17, une partie de la couche semi-conductrice 16, par exemple par gravure ionique réactive, dans une zone auxiliaire 22.

Dans cet empilement 14, on réalise ensuite (figure 3) l'orifice principal 6, par exemple par gravure ionique réactive, et éventuellement l'orifice auxiliaire 11 dans la zone 22 exempte de silicium polycristallin 16. Ces orifices s'étendent jusqu'à la région surdopée 2. On notera ici que l'épaisseur maximale de 1 µm adoptée pour ne pas conférer une résistance verticale d'accès au drain trop importante, reste compatible avec la réalisation selon les techniques classiques, d'un orifice 6 ayant un diamètre submicronique.

L'étape suivante consiste à former dans l'orifice 6 la région de canal 7, la couche inteme 23 et la région 8. A cet effet, on fait croître par épitaxie sélective dans l'orifice 6 du silicium de type N jusqu'au niveau de la couche semi-conductrice 16, puis on dépose une couche de silicium/germanium de façon à former la couche 23. Cette couche est surmontée d'un nouveau dépôt de silicium de type N jusqu'à la face supérieure de l'empilement et on effectue une implantation ionique de phosphore ou d'Arsenic par exemple, afin d'obtenir le surdopage de la région 8. On effectue également une épitaxie sélective dans l'orifice auxiliaire 11 suivie d'une implantation de phosphore de façon à obtenir la région 12.

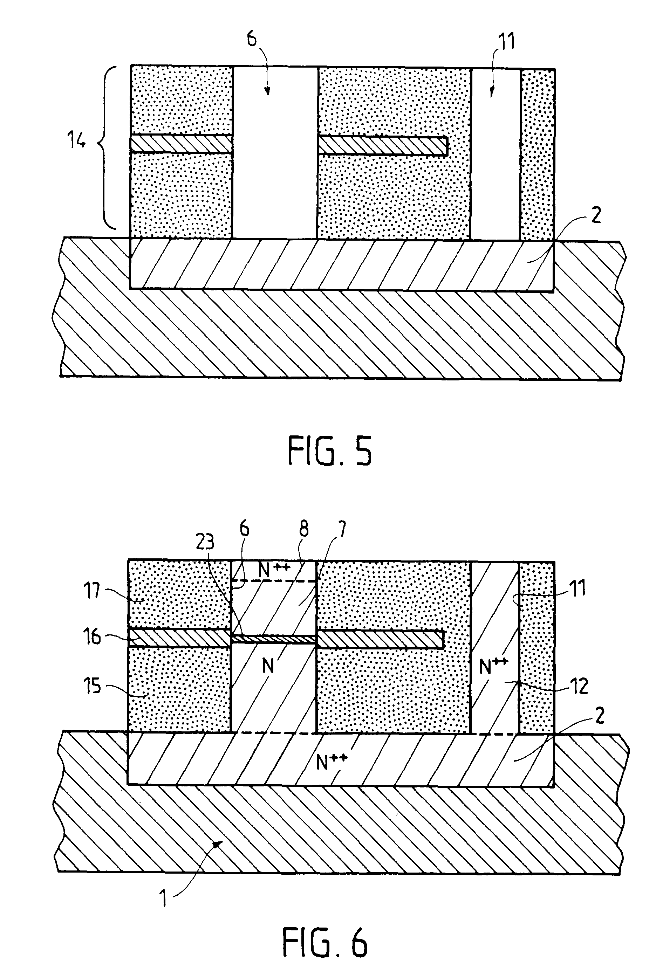

L'étape suivante (illustrée sur la figure 5) consiste à découvrir la face supérieure de la couche semi-conductrice 4 de l'empilement, dans une région située à distance autour de la région de canal 7, de façon à réaliser les espaceurs 5 d'épaisseur choisie. Le reste de l'empilement, situé dans la zone auxiliaire de l'orifice auxiliaire 11, a été de préférence arrasé dans le même plan que celui contenant la face supérieure de la couche semi-conductrice 4.

L'étape finale de ce procédé consiste à réaliser les métallisations 9, 10 et 13 par une technique connue du type salicide "self aligned silicide", qui comporte le dépôt d'une couche de métal (par exemple du titane) pour former un siliciure sur les zones de silicium semi-conductrices (TiSi₂).

Bien qu'il ait été utilisé ici une épitaxie sélective pour former les régions semi-conductrices à l'intérieur des orifices 6 et 11 du transistor, on aurait pu utiliser une simple épitaxie sur l'ensemble de l'empilement percé de ces orifices, suivie d'une étape de gravure afin d'éliminer les dépôts semi-conducteurs superflus.

De même, bien qu'il soit préférable d'effectuer l'opération de formation des espaceurs par gravure, après l'étape d'épitaxie sélective à l'intérieur de l'orifice 6, on pourrait concevoir de réaliser d'abord les espaceurs 5, puis d'effectuer l'épitaxie sélective à l'intérieur de l'orifice 6.

Bien que l'invention trouve ses pleins avantages dans le mode de réalisation décrit ci-dessus, il s'avère encore préférable d'utiliser dans certaines applications, un substrat sur isolant, au lieu d'un substrat massif, afin de minimiser les capacités parasites drain/substrat ou collecteur/substrat. Un tel substrat sur isolant 18 est illustré schématiquement sur la figure 6. Il comporte une région inférieure de silicium 19 surmontée d'une couche isolante 20 de dioxyde de silicium, elle-même surmontée d'une autre couche de silicium 21, de type P ou N, jouant le rôle du substrat 1 illustré sur les figures 1 à 5.

L'homme du métier connaît de tels substrats sous la dénomination SOI (Silicon on insulator).

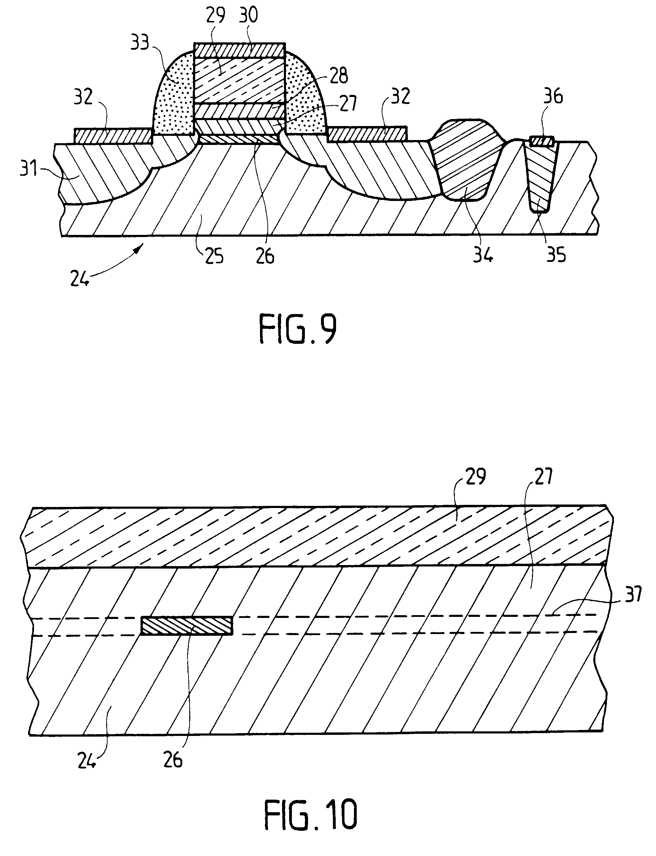

On se réfère maintenant plus particulièrement à la figure 9 pour décrire un mode de réalisation du transistor selon l'invention, dans une version compatible avec une technologie de fabrication CMOS (fabrication sur une même plaquette de transistors complémentaires à effet de champ à grille isolée) ou BiCMOS (adjonction de transistors bipolaire).

Sur un substrat 24 de silicium de type N, comportant dans sa partie inférieure une région 25 de drain surdopée, se situe une partie saillante dont les flancs sont recouverts d'espaceurs isolants 33. Cette partie saillante comporte à son sommet une métallisation 30 recouvrant la région 29 susceptible de former la source ou l'émetteur, réalisée ici en silicium polycristallin surdopé N⁺⁺. Sous cette région 29, se situe une couche 28 de silicium de type N surdopé N⁺⁺ qui a en fait été obtenue lors de la phase de recuit de la structure. Une couche 27 de silicium N se situe sous cette couche surdopée 28 et au-dessus de la couche interne 26 formée d'un alliage de silicium/germanium.

Cette couche interne 26 s'étend entre les régions de grille 31, de type P, implantées au sein du substrat 24. Ces régions sont surmontées d'une métallisation 32.

Le contact de drain 35, réalisé à partir de silicium surdopé N⁺⁺, et recouvert d'une métallisation 36, est séparé de la région de grille 31 par une région isolante 34, par exemple un dioxyde de silicium, implanté par la technique classique Locos ("Local oxydation of silicon").

Le procédé de fabrication d'une telle structure, concernant essentiellement la formation de la couche interne 26, est illustré sur les figures 10 à 12.

On dépose sur un substrat semi-conducteur 24 de silicium N, surdopé dans sa région inférieure, ou bien sur un substrat semi-conducteur de type P dans lequel a été réalisé un caisson N, une couche superficielle de silicium/germanium, puis on élimine une partie de cette couche superficielle dans une zone 37 pour mettre à nu la partie correspondante du substrat et délimiter ainsi la future couche interne 26.

On dépose alors sur la structure ainsi obtenue un empilement comportant une couche 27 de silicium de type N surmonté d'une couche 29 de silicium polycristallin de type N que l'on surdope de façon à lui conférer un surdopage de type N⁺⁺.

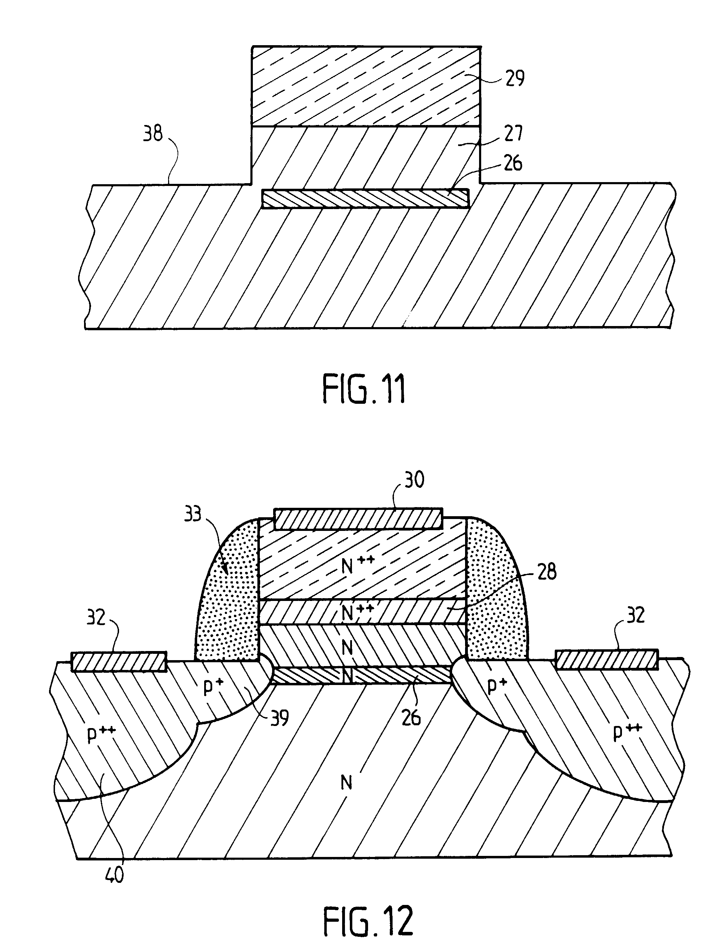

On retire ensuite par gravure, dans une zone située de part et d'autre de la couche interne 26, une partie de l'empilement ainsi formé jusqu'au voisinage supérieur de la couche interne 26 (figure 11), de façon à former la partie saillante du transistor à hétérojonction.

On effectue ensuite de part et d'autre de cette partie saillante, une première implantation de dopants choisis, de façon à conférer à ces zones implantées une conductivité de type P. On réalise ensuite, au contact des flancs de la partie saillante, les espaceurs 33, par exemple par dépôt de dioxyde de silicium, suivi d'une gravure anisotropique. On effectue alors une deuxième implantation de dopants de part et d'autre de la partie saillante équipée des espaceurs, de façon à obtenir un surdopage graduel de la région de grille (P⁺, P⁺⁺), comme illustré par les références 39 et 40 de la figure 12.

L'homme du métier comprendra qu'une telle structure de transistor et son procédé de fabrication, est compatible avec la technologie de fabrication du type CMOS, car elle permet d'utiliser en partie au moins des masquages identiques à ceux utilisés lors de la fabrication de ces transistors.

## Revendications

1. Transistor à effet de champ vertical à jonction comprenant une structure semi-conductrice comportant une région de drain, une région de source, une région de grille et une région de canal, caractérisé par le fait que la structure semi-conductrice comporte une couche interne semi-conductrice (23, 26) s'étendant au sein de la région de canal (7) entre la région de grille (4, 31), cette couche interne étant réalisée en un matériau semi-conducteur, ayant une largeur de bande interdite (Eg2) plus faible que celle du matériau formant la région de canal et la région de grille, et le même type de conductivité que celui de la région de canal, et par le fait que l'hétérojonction formée entre cette couche interne et la région de canal, présente une discontinuité de bande située dans la bande de valence dans le cas d'un canal de type N, ou dans la bande de conduction dans le cas d'un canal de type P.

2. Transistor selon la revendication 1, caractérisé par le fait que l'épaisseur de la couche interne semi-conductrice (23, 26) est de l'ordre de quelques nanomètres.

3. Transistor selon l'une des revendications précédentes, caractérisé par le fait que le matériau formant la région de grille et la région de canal est du silicium, tandis que le matériau formant la couche interne est un alliage de silicium/germanium.

4. Transistor selon l'une des revendications 1 à 3, caractérisé par le fait que le matériau formant la couche interne est un matériau III-V, tandis que le matériau formant les régions de grille et de canal est un alliage ternaire de ce matériau.

5. Transistor selon l'une des revendications précédentes, caractérisé par le fait que la structure semi-conductrice comprend :
- une région intermédiaire (7), susceptible de former la région de canal, ayant un premier type de conductivité (N), surmontant une première région (2), susceptible de former la région de drain, incluse dans le substrat (1), ayant également le premier type de conductivité (N⁺⁺),
- une partie saillante, incorporant une partie de la région de canal (7) et une deuxième région (8) surmontant la région de canal, susceptible de former la région de source, ayant également le premier type de conductivité (N⁺⁺),
par le fait que la région de grille (4) est séparée de la deuxième région (8) par une séparation isolante (5) disposée autour de la partie saillante, et par le fait que ladite couche interne s'étend au sein de la région intermédiaire entre la région de grille.

6. Transistor selon l'une des revendications précédentes, caractérisé par le fait que la structure semi-conductrice comporte une couche isolante (3) disposée à l'extérieur de la région de canal entre la région de grille et le substrat.

7. Transistor selon la revendication 6, caractérisé par le fait que la région de grille est une couche sensiblement parallèle au substrat, séparée de celui-ci par ladite couche isolante.

8. Transistor selon la revendication 6 ou 7, caractérisé par le fait que la couche isolante (3) a une épaisseur au moins égale à la largeur de la zone de charge d'espace d'une jonction P-N réalisée à partir du matériau semi-conducteur de base du transistor à effet de champ.

9. Transistor selon l'une des revendications 6 à 8, caractérisé par le fait que la couche isolante (3) a une épaisseur comprise entre environ 0,2 µm et environ 1 µm, de préférence de l'ordre de 0,5 µm.

10. Transistor selon l'une des revendications 6 à 9, caractérisé par le fait que les régions de canal, de source et de drain comportent du silicium mono-cristallin, tandis que la couche isolante comporte du bioxyde de silicium et que la région de grille comporte du silicium polycristallin.

11. Transistor selon l'une des revendications précédentes, caractérisé par le fait que les régions de drain (2), de source (8) et de grille (4) sont surdopées.

12. Transistor selon l'une des revendications précédentes, caractérisé par le fait que le substrat est un substrat sur isolant (18).

13. Utilisation du transistor selon l'une des revendications 1 à 12, comme transistor bipolaire, dans laquelle les régions de drain, source et grille constituent respectivement les régions de collecteur, émetteur et base du transistor bipolaire correspondant et dans laquelle on polarise la grille en direct par rapport à la source.

14. Procédé de fabrication d'un transistor à effet de champ vertical à jonction utilisable comme transistor bipolaire, caractérisé par le fait que :
a) on forme sur un substrat semi-conducteur (1, 18) contenant une première région (2) ayant un premier type de conductivité, un empilement (14) comportant une couche (16) d'un matériau semi-conducteur, ayant un type de conductivité opposé au premier type, encadrée par deux couches (15, 17) de matériaux isolants,
b) on réalise dans l'empilement un orifice principal (6) s'étendant jusqu'à la première région (2),
c) on forme dans l'orifice principal (6) une région intermédiaire (7) à partir d'un matériau semi-conducteur ayant le premier type de conductivité, une couche interne (23) en un matériau semi-conducteur ayant le premier type de conductivité et une largeur de- bande interdite plus faible que celle du matériau de la région intermédiaire (7) et apte à former une hétérojonction comportant une discontinuité de bande située dans la bande de valence dans le cas où le premier type de conductivité est N et dans la bande de conduction dans le cas où le premier type de conductivité est P, ainsi qu'une deuxième région (8) au-dessus de la région intermédiaire, ayant également le premier type de conductivité,
d) on découvre la face supérieure de la couche semi-conductrice (16) de l'empilement (14) dans une région située à distance autour de la région intermédiaire (7), et
e) on réalise des métallisations (9, 10, 13) sur une partie au moins de la première et de la deuxième régions (2, 8), ainsi que sur une partie au moins de la couche semi-conductrice de l'empilement (4), découverte.

15. Procédé selon la revendication 14, caractérisé par le fait que l'étape c) comprend un premier dépôt par épitaxie pour former la partie inférieure de la région intermédiaire, puis un second dépôt par épitaxie pour former la couche interne et un troisième dépôt par épitaxie pour former la partie supérieure de la région intermédiaire et la deuxième région (8).

16. Procédé selon la revendication 15, caractérisé par le fait que les dépôts par épitaxie sont des dépôts par épitaxie sélective à l'intérieur de l'orifice principal.

17. Procédé selon l'une des revendications 14 à 16, caractérisé par le fait que l'étape de formation de l'orifice principal (6) ainsi que l'étape d) comprennent une opération de gravure.

18. Procédé selon l'une des revendications 14 à 17, caractérisé
par le fait que, dans l'étape a), on dépose la couche semi-conductrice (16) sur la première couche isolante (15), puis on retire la partie de cette couche semi-conductrice (16) dans une zone auxiliaire située à distance de celle dans laquelle sera aménagé ledit orifice principal (6), et on dépose ensuite la deuxième couche isolante (17),
par le fait que l'on réalise dans l'empilement un orifice auxiliaire (11) dans ladite zone auxiliaire s'étendant jusqu'à la première région (2),
par le fait que l'on forme dans cet orifice auxiliaire (11) une région (12), de préférence surdopée, ayant le même type de conductivité que la première région (2),
et l'on réalise une métallisation (13) sur la face supérieure de la région semi-conductrice (12) contenue dans l'orifice auxiliaire (11).

19. Procédé de fabrication d'un transistor à effet de champ vertical à jonction utilisable comme transistor bipolaire, caractérisé par le fait que
a/ on dépose sur un substrat semi-conducteur (24) comportant une première région (25) ayant un premier type de conductivité (N⁺), une couche superficielle en un matériau semi-conducteur ayant le premier type de conductivité et une largeur de bande interdite plus faible que celle du matériau de la première région (25), et apte à former une hétérojonction comportant une discontinuité de bande située dans la bande de valence, dans le cas où le premier type de conductivité est N et dans la bande de conduction dans le cas où le premier type de conductivité est P,
b/ on élimine une partie de cette couche superficielle pour mettre à nu la partie correspondante du substrat et délimiter ainsi une couche dite interne (26),
c/ on dépose sur la structure ainsi obtenue, un empilement comportant une autre couche (27) d'un matériau semi-conducteur identique à celui formant ladite première région (25), puis une couche supérieure (29) en un autre matériau semi-conducteur ayant également le premier type de conductivité,
d/ on retire, dans une zone (37) située de part et d'autre de la couche interne (26), une partie de l'empilement jusqu'au voisinage supérieur de ladite couche interne (26), de façon à former une partie saillante comportant dans sa partie supérieure une partie de la couche supérieure formant une deuxième région (29),
e/ on implante dans le substrat, de part et d'autre de la partie saillante, une troisième région (31) venant au contact de la couche interne (26) et ayant un type de conductivité opposé au premier, et on réalise des espaceurs isolants au contact des flancs de la partie saillante,
f) on réalise des métallisations (30, 32, 36) sur une partie au moins de la première et de la deuxième régions ainsi que sur une partie au moins de la couche semi-conductrice de l'empilement découvete.

20. Procédé selon la revendication 19, caractérisé par le fait que le matériau formant la deuxième région est du silicium polycristallin surdopé.

21. Procédé selon la revendication 19 ou 20, caractérisé par le fait que dans l'étape e/, on effectue une première implantation de dopants choisis, puis on réalise les espaceurs et on effectue ensuite une deuxième implantation choisie, de façon à obtenir un surdopage graduel de la troisième région.

## Patentansprüche

1. Vertikaler Sperrschicht-Feldeffekttransistor (JFET) mit einer Halbleiterstruktur, welche einen Drain-Bereich, einen Source-Bereich, einen Gate-Bereich und einen Kanal-Bereich umfaßt,
dadurch gekennzeichnet, daß
die Halbleiterstruktur eine innere halbleitende Schicht (23, 26) umfaßt, welche sich im Inneren des Kanal-Bereichs (7) innerhalb des Gate-Bereichs (4, 31) erstreckt, wobei diese innere Schicht aus einem Halbleitermaterial gebildet ist, das eine geringere Breite des verbotenen Bandes (Eg2) als das den Kanal-Bereich und den Gate-Bereich bildende Material und den gleichen Leitungstyp wie der Kanal-Bereich aufweist, und daß der zwischen der inneren Schicht und dem Kanal-Bereich gebildete Heteroübergang eine Band-Diskontinuität aufweist, die im Fall eines Kanals vom N-Typ im Valenz-Band oder im Fall eines Kanals vom P-Typ im Leitungsband gelegen ist.

2. Transistor nach Anspruch 1, dadurch gekennzeichnet, daß die Dicke der inneren halbleitenden Schicht (23, 26) in der Größenordnung von einigen Nanometern liegt.

3. Transistor nach einem der vorangehenden Ansprüche, dadurch gekennzeichnet, daß das den Gate-Bereich und den Kanal-Bereich bildende Material Silicium ist, während das die innere Schicht bildende Material eine Silicium/Germanium-Legierung ist.

4. Transistor nach einem der Ansprüche 1 bis 3, dadurch gekennzeichnet, daß das die innere Schicht bildende Material ein III-V-Material ist, während das den Gate-Bereich und den Kanal-Bereich bildende Material eine Dreistofflegierung dieses Materials ist.

5. Transistor nach einem der vorangehenden Ansprüche, dadurch gekennzeichnet, daß die Halbleiterstruktur umfaßt:
- einen Zwischenbereich (7), der den Kanal-Bereich zu bilden vermag, mit einem ersten Leitungstyp (N), welcher einen ersten Bereich (2), der den Drain-Bereich zu bilden vermag und der in dem Substrat (1) eingeschlossen ist, überragt und ebenfalls den ersten Leitungstyp (N⁺⁺) aufweist,
- einen vorspringenden Abschnitt, der einen Abschnitt des Kanal-Bereichs (7) und einen zweiten den Kanal-Bereich überragenden Bereich (8) umfaßt, der den Source-Bereich zu bilden vermag, welcher ebenfalls den ersten Leitungstyp (N⁺⁺) aufweist,
daß der Gate-Bereich (4) von dem zweiten Bereich (8) durch eine isolierende, um den vorspringenden Abschnitt herum angeordnete Trennwand (5) getrennt ist und
daß die genannte innere Schicht sich im Inneren des Zwischenbereichs innerhalb des Gate-Bereichs erstreckt.

6. Transistor nach einem der vorangehenden Ansprüche, dadurch gekennzeichnet, daß die Halbleiterstruktur eine Isolationsschicht (3) umfaßt, welche außerhalb des Kanal-Bereichs zwischen dem Gate-Bereich und dem Substrat angeordnet ist.

7. Transistor nach Anspruch 6, dadurch gekennzeichnet, daß der Gate-Bereich eine zum Substrat annähernd parallele Schicht ist, die von dieser durch die genannte Isolationsschicht getrennt ist.

8. Transistor nach Anspruch 6 oder 7, dadurch gekennzeichnet, daß die Isolationsschicht (3) eine Dicke besitzt, die mindestens gleich ist der Breite der Raumladungszone eines P-N-Übergangs, der auf der Grundlage des Basis-Halbleitermaterials des Feldeffekttransistors erzeugt wird.

9. Transistor nach einem der Ansprüche 6 bis 8, dadurch gekennzeichnet, daß die Isolationsschicht (3) eine Dicke zwischen etwa 0,2 µm und etwa 1 µm, vorzugsweise in der Größenordnung von 0,5 µm, besitzt.

10. Transistor nach einem der Ansprüche 6 bis 9, dadurch gekennzeichnet, daß der Kanal-Bereich, der Source-Bereich und der Drain-Bereich monokristallines Silicium enthalten, während die Isolationsschicht Siliciumdioxid und der Gate-Bereich polykristallines Silicium enthalten.

11. Transistor nach einem der vorangehenden Ansprüche, dadurch gekennzeichnet, daß der Drain-Bereich (2), der Source-Bereich (8) und der Gate-Bereich (4) überdotiert sind.

12. Transistor nach einem der vorangehenden Ansprüche, dadurch gekennzeichnet, daß das Substrat ein Substrat auf einem Isolator (18) ist.

13. Verwendung des Transistors nach einem der Ansprüche 1 bis 12 als Bipolartransistor, bei dem der Drain-Bereich, der Source-Bereich und der Gate-Bereich jeweils den Kollektor-, Emitter- bzw. den Basis-Bereich des entsprechenden Bipolartransistors bilden und bei dem das Gate direkt gegenüber der Source polarisiert wird.

14. Verfahren zur Herstellung eines vertikalen Sperrschicht-Feldeffekttransistors, der als Bipolartransistor verwendbar ist,
dadurch gekennzeichnet,
a) daß auf einem Halbleitersubstrat (1, 18), das einen ersten Bereich (2) mit einem ersten Leitungstyp enthält, eine Schichtung (14) geformt wird, welche eine Schicht (16) eines Halbleitermaterials mit einem zu dem ersten Leitungstyp entgegengesetzten Leitungstyp aufweist, welche von zwei Schichten (15, 17) aus isolierenden Materialien eingeschlossen ist,
b) daß in der Schichtung eine Hauptöffnung (6) erzeugt wird, welche sich bis zu dem ersten Bereich (2) erstreckt,
c) daß in der Hauptöffnung (6) ein Zwischenbereich (7) auf der Grundlage eines Halbleitermaterials mit dem ersten Leitungstyp gebildet wird, ferner eine innere Schicht (23) aus einem Halbleitermaterial mit dem ersten Leitungstyp und mit einer Breite des verbotenen Bandes, die geringer ist als die des Materials des Zwischenbereichs (7) und die einen Heteroübergang zu bilden vermag, der eine Band-Diskontinuität aufweist, welche im Valenz-Band liegt, falls der erste Leitungstyp N ist, und welche im Leitungsband liegt, falls der erste Leitungstyp P ist, sowie ein zweiter Bereich (8) oberhalb des Zwischenbereichs, der ebenfalls den ersten Leitungstyp besitzt,
d) daß die Oberseite der Halbleiterschicht (16) der Schichtung (14) in einem Bereich freigelegt wird, welcher im Abstand um den Zwischenbereich (7) herum liegt, und
e) daß Metallisierungen (9, 10, 13) zumindest auf einem Teil des ersten und des zweiten Bereichs (2, 8) sowie auf mindestens einem Teil der freigelegten Halbleiterschicht der Schichtung (4) erzeugt werden.

15. Verfahren nach Anspruch 14, dadurch gekennzeichnet, daß der Schritt c) eine erste Ablagerung durch Epitaxie zur Bildung des unteren Teils des Zwischenbereichs, sodann eine zweite Ablagerung durch Epitaxie zur Bildung der inneren Schicht und eine dritte Ablagerung durch Epitaxie zur Bildung des oberen Teils des Zwischenbereichs und des zweiten Bereichs (8) umfaßt.

16. Verfahren nach Anspruch 15, dadurch gekennzeichnet, daß die Ablagerungen durch Epitaxie jeweils Ablagerungen durch selektive Epitaxie im Inneren der Hauptöffnung sind.

17. Verfahren nach einem der Ansprüche 14 bis 16, dadurch gekennzeichnet, daß der Schritt zur Bildung der Hauptöffnung (6) sowie der Schritt d) jeweils einen Ätzvorgang umfassen.

18. Verfahren nach einem der Ansprüche 14 bis 17, dadurch gekennzeichnet, daß beim Schritt a) die Halbleiterschicht (16) auf der ersten Isolationsschicht (15) abgelagert wird, daß dann der Teil dieser Halbleiterschicht (16) in einer Hilfszone entfernt wird, welche im Abstand zu derjenigen liegt, in der die genannte Hauptöffnung (6) angebracht werden wird, und danach die zweite Isolationsschicht (17) abgelagert wird,
daß in der Schichtung eine Hilfsöffnung (11) in der genannten Hilfszone erzeugt wird, die sich bis zu dem ersten Bereich (2) erstreckt,
daß in dieser Hilfsöffnung (11) ein Bereich (12) ausgebildet wird, vorzugsweise durch Überdotierung, der den gleichen Leitungstyp wie der erste Bereich (2) besitzt, und
daß eine Metallisierung (13) auf der Oberseite der in der Hilfsöffnung (11) enthaltenen Halbleiterschicht (12) erzeugt wird.

19. Verfahren zur Herstellung eines vertikalen Sperrschicht-Feldeffekttransistors, der als Bipolartransistor verwendbar ist, dadurch gekennzeichnet,
a) daß auf einem Halbleitersubstrat (24), welches einen ersten Bereich (25) mit einem ersten Leitungstyp (N⁺) besitzt eine Oberflächenschicht aus einem Halbleitermaterial erzeugt wird, welches den ersten Leitungstyp und eine Breite des verbotenen Bandes, die geringer ist als diejenige des Materials des ersten Bereichs (25), aufweist und einen Heteroübergang zu bilden vermag, der eine Band-Diskontinuität aufweist, welche im Valenz-Band liegt, falls der erste Leitungstyp N ist, und welche im Leitungsband liegt, falls der erste Leitungstyp P ist,
b) daß ein Teil dieser Oberflächenschicht entfernt wird, um den entsprechenden Teil des Substrats freizulegen und so eine sogenannte innere Schicht (26) zu begrenzen,
c) daß auf der so erhaltenen Struktur eine Schichtung, welche eine weitere Schicht (27) aus einem Halbleitermaterial umfaßt, das identisch ist mit dem, welches den genannten ersten Bereich (25) bildet, und dann eine obere Schicht (29) aus einem anderen Halbleitermaterial mit ebenfalls dem ersten Leitungstyp abgelagert wird,
d) daß in einer beiderseits der inneren Schicht (26) gelegenen Zone (37) ein Teil der Schichtung bis an den oberen angrenzenden Nachbarschaftsbereich der genannten inneren Schicht (26) entfernt wird, um einen vorspringenden Abschnitt zu bilden, welcher in seinem oberen Teil einen Teil der einen zweiten Bereich (29) bildenden oberen Schicht umfaßt,
e) daß in das Substrat beiderseits des vorspringenden Abschnitts ein dritter Bereich (31) implantiert wird, welcher in Kontakt mit der inneren Schicht (26) gelangt, und einen dem ersten Leitungstyp entgegengesetzten Leitungstyp besitzt, und daß isolierende Zwischenwände im Kontakt mit den Seiten des vorspringenden Abschnitts erzeugt werden, und
f) daß Metallisierungen (30, 32, 36) auf mindestens einem Teil des ersten und des zweiten Bereichs sowie mindestens auf einem Teil der Halbleiterschicht der freigelegten Schichtung erzeugt werden.

20. Verfahren nach Anspruch 19, dadurch gekennzeichnet, daß das den zweiten Bereich bildende Material aus überdotiertem polykristallinem Silicium besteht.

21. Verfahren nach Anspruch 19 oder 20, dadurch gekennzeichnet, daß beim Schritt e) eine erste Implantation mit ausgewählten Dotierstoffen durchgeführt wird, daß dann die Trennwände erzeugt werden und daß danach eine zweite ausgewählte Implantation durchgeführt wird, um eine graduelle Überdotierung des dritten Bereiches zu erhalten.

## Claims

1. Vertical junction field-effect transistor, comprising a semiconductor structure including a drain region, a source region, a gate region and a channel region, characterised in that the semiconductor structure includes an internal semiconductor layer (23, 26) extending within the channel region (7) between the gate region (4, 31), this internal layer being produced in a semiconductor material, having an energy gap (Eg2) smaller than that of the material forming the channel region and the gate region, and the same type of conductivity as that of the channel region, and in that the heterojunction formed between this internal layer and the channel region exhibits a band discontinuity lying in the valence band in the case of an N-type channel, or in the conduction band in the case of a P-type channel.

2. Transistor according to Claim 1, characterised in that the thickness of the internal semiconductor layer (23, 26) is of the order of a few nanometres.

3. Transistor according to one of the preceding claims, characterised in that the material forming the gate region and the channel region is silicon, while the material forming the internal layer is a silicon/ germanium alloy.

4. Transistor according to one of Claims 1 to 3, characterised in that the material forming the internal layer is a III-V material, while the material forming the gate and channel regions is a ternary alloy of this material.

5. Transistor according to one of the preceding claims, characterised in that the semiconductor structure comprises:
- an intermediate region (7), capable of forming the channel region, having a first type of conductivity (N), surmounting a first region (2) capable of forming the drain region, included in the substrate (1), also having the first type of conductivity (N⁺⁺),
- a projecting part, incorporating a part of the channel region (7) and a second region (8) surmounting the channel region, capable of forming the source region, also having the first type of conductivity (N⁺⁺),
in that the gate region (4) is separated from the second region (8) by an insulating separation (5) arranged around the projecting part, and in that the said internal layer extends within the intermediate region between the gate region.

6. Transistor according to one of the preceding claims, characterised in that the semiconductor structure includes an insulating layer (3) arranged outside the channel region between the gate region and the substrate.

7. Transistor according to Claim 6, characterised in that the gate region is a layer substantially parallel to the substrate, separated from the latter by the said insulating layer.

8. Transistor according to Claim 6 or 7, characterised in that the insulating layer (3) has a thickness at least equal to the width of the space charge region of a P-N junction produced from the basic semiconductor material of the field-effect transistor.

9. Transistor according to one of Claims 6 to 8, characterised in that the insulating layer (3) has a thickness lying between about 0.2 µm and about 1 µm, preferably of the order of 0.5 µm.

10. Transistor according to one of Claims 6 to 9, characterised in that the channel, source and drain regions include monocrystalline silicon, while the insulating layer includes silicon dioxide and that the gate region includes polycrystalline silicon.

11. Transistor according to one of the preceding claims, characterised in that the drain (2), source (8) and gate (4) regions are overdoped.

12. Transistor according to one of the preceding claims, characterised in that the substrate is a substrate on insulator (18).

13. Use of the transistor according to one of Claims 1 to 12, as a bipolar transitor [sic], in which the drain, source and gate regions constitute respectively the collector, emitter and base regions of the corresponding bipolar transistor and in which the gate is forward-biased with respect to the source.

14. Method of fabricating a vertical junction field-effect transistor which may be used as a bipolar transistor, characterised in that:
a) on a semiconductor substrate (1, 18) containing a first region (2) having a first type of conductivity, a stacking (14) is formed, including a layer (16) of a semiconductor material, having a type of conductivity opposite to the first type, framed by two layers (15, 17) of insulating materials,
b) in the stack is produced a main orifice (6) extending as far as the first region (2),
c) in the main orifice (6) is formed an intermediate region (7) from a semiconductor material having the first type of conductivity, an internal layer (23) in a semiconductor material having the first type of conductivity and an energy gap smaller than that of the material of the intermediate region (7) and able to form a heterojunction including a band discontinuity situated in the valence band in the case in which the first type of conductivity is N and in the conduction band in the case in which the first type of conductivity is P, as well as a second region (8) above the intermediate region, also having the first type of conductivity.
d) the upper face of the semiconductor layer (16) of the stack (14) is uncovered in a region situated at a distance about the intermediate region (7), and
e) metallisations (9, 10, 13) are produced on at least a part of the first and of the second regions (2, 8), as well as on at least a part of the uncovered semiconductor layer of the stack (4) [sic].

15. Method according to Claim 14, characterised in that step c) comprises a first deposition by epitaxy in order to form the lower part of the intermediate region, then a second deposition by epitaxy in order to form the internal layer and a third deposition by epitaxy in order to form the upper part of the intermediate region and the second region (8).

16. Method according to Claim 15, characterised in that the depositions by epitaxy are depositions by selective epitaxy within the main orifice.

17. Method according to one of Claims 14 to 16, characterised in that the step of forming the main orifice (6) as well as step d) comprise an etching operation.

18. Method according to one of Claims 14 to 17, characterised
in that, in step a), the semiconductor layer (16) is deposited onto the first insulating layer (15), then the part of this semiconductor layer (16) is removed in an auxiliary area situated at a distance from that in which the said main orifice (6) will be created, and next the second insulating layer (17) is deposited,
in that in the stacking an auxiliary orifice (11) is produced in the said auxiliary area extending as far as the first region (2)
in that, in this auxiliary orifice (11), a region (12), preferably overdoped, is formed, having the same type of conductivity as the first region (2),
and a metallisation (13) is carried out on the upper face of the semiconductor region (12) contained in the auxiliary orifice (11).

19. Method of fabricating a vertical junction field-effect transistor which may be used as a bipolar transistor, characterised in that
a/ on a semiconductor substrate (24) including a first region (25) having a first type of conductivity (N⁺), there is deposited a superficial layer made of a semiconductor material having the first type of conductivity and an energy gap smaller than that of the material of the first region (25), and able to form a heterojunction including a band discontinuity situated in the valence band, in the case in which the first type of conductivity is N and in the conduction band in the case in which the first type of conductivity is P,
b/ a part of this superficial layer is removed in order to lay bare the corresponding part of the substrate and thus delimit a layer known as internal layer (26),
c/ on the structure thus obtained there is deposited a stack including another layer (27) of a semiconductor material identical to that forming the said first region (25), then an upper layer (29) made of another semiconductor material also having the first type of conductivity,
d/ in an area (37) situated on either side of the internal layer (26) a part of the stack is removed as far as the upper vicinity of the said internal layer (26) so as to form a projecting part including, in its upper part, a part of the upper layer forming a second region (29),
e/ in the substrate, on either side of the projecting part, is implanted a third region (31), coming into contact with the internal layer (26) and having a type of conductivity opposite to the first, and insulating spacers are produced in contact with the sides of the projecting part,
f/ metallisations (30, 32, 36) are produced on at least a part of the first and of the second regions as well as on at least a part of the uncovered semiconductor layer of the stack.

20. Method according to Claim 19, characterised in that the material forming the second region is overdoped polycrystalline silicon.

21. Method according to Claim 19 or 20, characterised in that in step e/, a first implantation of chosen dopants is performed, then the spacers are produced and next a second chosen implantation is performed, so as to obtain a gradual overdoping of the third region.
